# EUROPÄISCHE PATENTSCHRIFT

(11) **EP 3 474 646 B1**
(45) Veröffentlichungstag und Bekanntmachung des Hinweises auf die Patenterteilung: **07.04.2021**
(21) Anmeldenummer: 18198905.4
(22) Anmeldetag: 05.10.2018
(51) Int. Cl.: H05K 7/14, H01R 9/26, H01R 31/06

(54) **TRAGSCHIENENGEHÄUSE, ELEKTRONIKMODUL MIT EINEM TRAGSCHIENENGEHÄUSE UND SYSTEM, INSBESONDERE STEUERUNGSSYSTEM, MIT EINER MEHRZAHL VON ELEKTRONIKMODULEN**
SUPPORT RAIL HOUSING, ELECTRONIC MODULE WITH A SUPPORT RAIL HOUSING AND SYSTEM, IN PARTICULAR CONTROL SYSTEM, WITH A PLURALITY OF ELECTRONIC MODULES
BOÎTIER DE RAIL DE GUIDAGE, MODULE ÉLECTRONIQUE DOTÉ D'UN BOÎTIER DE RAIL DE GUIDAGE ET SYSTÈME, EN PARTICULIER UN SYSTÈME DE COMMANDE, DOTÉ D'UNE PLURALITÉ DE MODULES ÉLECTRONIQUES

(30) Priorität: 23.10.2017 DE 102017124706
(43) Veröffentlichungstag der Anmeldung: 24.04.2019
(73) Patentinhaber: Pilz GmbH & Co. KG, 73760 Ostfildern (DE)
(72) Erfinder: Merz, Lothar, 73760 Ostfildern (DE)
(74) Vertreter: Schäperklaus, Jochen

(56) Entgegenhaltungen:
- DE-A1-102013 112 099
- DE-A1-102013 112 101
- US-A1- 2007 246 256

## Beschreibung

Die vorliegende Erfindung betrifft ein Tragschienengehäuse, geeignet zur Anbringung an einer Tragschiene, insbesondere einer Hutschiene, nach dem Oberbegriff des Anspruchs 1.

Aus dem Stand der Technik sind Systeme, insbesondere Steuerungssysteme, der eingangs genannten Art, die modular aus mehreren Elektronikmodulen aufgebaut sind, in unterschiedlichen Ausführungsformen bekannt. Der modulare Aufbau dieser Systeme schafft die Möglichkeit einer anwendungsspezifischen Konfiguration, indem mehrere Elektronikmodule individuell zusammengestellt werden können, um dem System die gewünschten Funktionalitäten zur Verfügung zu stellen. Beispiele für derartige Elektronikmodule, aus denen Steuerungssysteme mit ganz unterschiedlichen Funktionalitäten aufgebaut werden können, sind unter anderem Steuerungsmodule, Schnittstellenmodule, Feldbuscontroller, Feldbuskoppler, Eingangsmodule, die Eingangssignale eines oder mehrerer Sensoren empfangen und gegebenenfalls verarbeiten können, Ausgangsmodule, die Ausgangssignale an einen oder mehrere daran angeschlossene Aktoren ausgeben können, oder auch kombinierte Eingangs- und Ausgangsmodule (so genannte I/O-Module).

Jedes der Elektronikmodule, aus denen das System aufgebaut ist, weist ein Tragschienengehäuse auf, das so ausgebildet ist, dass es mit einer Tragschiene, insbesondere einer Hutschiene, verrastet werden kann. Die Tragschiene kann ihrerseits innerhalb eines Schaltschranks untergebracht sein. Somit können die Elektronikmodule des Systems nebeneinander auf der Tragschiene verrastet werden. Um eine Kommunikation zwischen den Elektronikmodulen zu ermöglichen, werden diese mittels eines Busverbinders paarweise miteinander verbunden. Ferner ist es möglich, den Elektronikmodulen mittels der Busverbinder eine elektrische Versorgungspannung zur Verfügung zu stellen.

Bei den aus dem Stand der Technik bekannten Tragschienengehäusen kommen unterschiedliche Befestigungskonzepte für die Befestigung der Tragschienengehäuse an der Tragschiene einerseits und für die Befestigung der Busverbinder an den Elektronikmodulen andererseits zum Einsatz, so dass die Montage der Busverbinder sowie die Montage der Tragschienengehäuse an der Tragschiene relativ aufwändig sind.

Ein gattungsgemäßes Tragschienengehäuse ist zum Beispiel aus der US 2007/246256 A1 bekannt.

Die vorliegende Erfindung macht es sich zur Aufgabe, ein Tragschienengehäuse der eingangs genannten Art sowie ein gattungsgemäßes Elektronikmodul zu schaffen, die einfacher montierbar sind. Darüber hinaus liegt der vorliegenden Erfindung die Aufgabe zugrunde, ein System, insbesondere ein Steuerungssystem zur Verfügung zu stellen, das eine einfachere Montage und ein besonders sicheres Handling ermöglicht.

Die Lösung dieser Aufgaben liefern ein Tragschienengehäuse der eingangs genannten Art mit den Merkmalen des kennzeichnenden Teils des Anspruchs 1, ein gattungsgemäßes Elektronikmodul mit den Merkmalen des kennzeichnenden Teils des Anspruchs 7 sowie ein System, insbesondere ein Steuerungssystem, der eingangs genannten Art mit den Merkmalen des kennzeichnenden Teils des Anspruchs 8. Die Unteransprüche betreffen vorteilhafte Weiterbildungen der Erfindung.

Ein erfindungsgemäßes Tragschienengehäuse zeichnet sich dadurch aus, dass der Busverbinder einen Grundkörper mit zwei einander gegenüberliegenden Enden umfasst, an denen jeweils eine Schrägfläche ausgebildet ist, wobei die Schrägflächen dazu eingerichtet sind, die Rastschieber beim Einsetzen des Busverbinders in die Tragschienenaufnahmeöffnung des Tragschienengehäuses nach außen zu verschieben. Mit anderen Worten werden also die Rastschieber beim Einsetzen des Busverbinders in die Tragschienenaufnahmeöffnung selbsttätig nach außen verschoben und weichen somit dem Busverbinder aus. Das erfindungsgemäße Tragschienengehäuse ermöglicht eine besonders einfache Montage und stellt darüber hinaus einen sicheren Halt des Busverbinders an dem Tragschienengehäuse zur Verfügung. Dadurch wird erreicht, dass der Busverbinder unverlierbar mit dem betreffenden Tragschienengehäuse verbunden ist. Die Montage des Busverbinders an dem Tragschienengehäuse kann zum Beispiel automatisiert in einer Montagestation erfolgen, so dass die Montagekosten verringert werden können.

In einer bevorzugten Ausführungsform wird vorgeschlagen, dass jeder der Rastschieber ein Rastelement umfasst und dass das Tragschienengehäuse zwei Rastausnehmungen aufweist, wobei in der Verriegelungsstellung der Rastschieber in jede der beiden Rastausnehmungen eines der Rastelemente eingreift. Dadurch wird in der Verriegelungsstellung ein sicherer Halt der Rastschieber, deren Rastelemente eine entsprechende Haltekraft aufbringen, an dem Tragschienengehäuse erreicht.

In einer besonders bevorzugten Ausführungsform kann vorgesehen sein, dass die Rastelemente als Biegebalken ausgebildet sind, die sich von dem Halteabschnitt in Richtung eines zweiten Endes des betreffenden Rastschiebers erstrecken und einen Rastvorsprung umfassen, der in der Verriegelungsstellung in die dem Rastschieber zugeordnete Rastausnehmung eingreift. Diese Ausführungsform hat den Vorteil, dass die als Biegebalken ausgebildeten Rastelemente mechanisch sehr robust ausgeführt sind und die Haltekräfte zuverlässig bereitstellen können.

In einer vorteilhaften Ausführungsform kann jeder der Biegebalken so ausgebildet sein, dass er bei einer Verschiebung des Rastschiebers nach außen von der Tragschienenaufnahmeöffnung weg im Zusammenwirken mit der Rastausnehmung, in die der Rastvorsprung eingreift, eine auf den Rastschieber in Richtung der Tragschienenaufnahmeöffnung wirkende Rückstellkraft erzeugt. Dadurch wird erreicht, dass die Rastschieber nach der Montage des Busverbinders selbsttätig zurückfedern, so dass sich die Halteabschnitte wieder abschnittsweise in die Tragschienenaufnahmeöffnung hinein erstrecken und somit den sicheren Halt des Busverbinders gewährleisten.

In einer bevorzugten Ausführungsform besteht die Möglichkeit, dass sich die Halteschenkel in der Montagesolllage der Tragschiene zwischen dem Busverbinder und den Halteabschnitten der Rastschieber erstrecken. Dadurch wird ein besonders sicherer Halt des Tragschienengehäuses an der Tragschiene erreicht. Darüber hinaus wird eine Erdung des innerhalb des Tragschienengehäuses angeordneten Steckkontaktelements an der Tragschiene ermöglicht.

Um die Rastschieber auf einfache Weise aus ihrer Verriegelungsstellung in eine Entriegelungsstellung, in der sie nicht mehr mit dem Tragschienengehäuse verrasten, überführen zu können, wird in einer besonders bevorzugten Ausführungsform vorgeschlagen, dass jeder der Rastschieber einen Handhabungsabschnitt aufweist, der an einem zweiten Ende, welches dem ersten Ende gegenüberliegt, ausgebildet ist.

Ein erfindungsgemäßes Elektronikmodul, welches ein Tragschienengehäuse umfasst, das an einer Tragschiene, insbesondere einer Hutschiene, anbringbar ist, zeichnet sich gemäß Anspruch 7 dadurch aus, dass das Tragschienengehäuse nach einem der Ansprüche 1 bis 6 ausgeführt ist. Das erfindungsgemäße Elektronikmodul kann sehr einfach an einer Tragschiene montiert werden und mittels des Busverbinders mit einem oder mehreren Elektronikmodulen in besonders zuverlässiger Weise mechanisch und elektrisch verbunden werden und zu einem System, insbesondere einem Steuerungssystem, kombiniert werden. Innerhalb des Tragschienengehäuses des Elektronikmoduls ist zumindest eine Leiterplatte mit elektronischen und/oder elektromechanischen Bauteilen untergebracht, die dem Elektronikmodul bestimmte Funktionen zur Verfügung zu stellen.

Ein erfindungsgemäßes System, insbesondere ein Steuerungssystem, das eine Mehrzahl von Elektronikmodulen aufweist, zeichnet sich gemäß Anspruch 8 dadurch aus, dass zumindest eines der Elektronikmodule nach Anspruch 7 ausgeführt ist und mittels des Busverbinders elektrisch und mechanisch mit einem benachbarten Elektronikmodul verbunden ist. Die Elektronikmodule, aus denen das erfindungsgemäße System, das insbesondere ein Steuerungssystem sein kann, können unter anderem Steuerungsmodule, Schnittstellenmodule, Feldbuscontroller, Feldbuskoppler, Eingangsmodule, die Eingangssignale eines oder mehrerer Sensoren empfangen und gegebenenfalls verarbeiten können, Ausgangsmodule, die Ausgangssignale an einen oder mehrere daran angeschlossene Aktoren ausgeben können, oder auch kombinierte Eingangs- und Ausgangsmodule (so genannte I/O-Module) sein. Das erfindungsgemäße System, das insbesondere ein Steuerungssystem sein kann, kann somit aus mehreren Elektronikmodulen modular aufgebaut werden, wobei von einer Gesamtanzahl n von Elektronikmodulen des Systems vorzugsweise zumindest n-1 Elektronikmodule nach Anspruch 7 ausgeführt sind, so dass benachbarte Elektronikmodule mittels der unverlierbar an den Tragschienengehäusen angebrachten Busverbinder miteinander verbunden werden können. Dieser modulare Aufbau des Systems schafft in besonders vorteilhafter Weise die Möglichkeit einer anwendungsspezifischen Konfiguration, indem mehrere Elektronikmodule bereits beim Hersteller individuell zusammengestellt werden können, um dadurch dem System, insbesondere dem Steuerungssystem, die gewünschten Funktionalitäten zur Verfügung zu stellen.

Die Zusammenstellung der einzelnen Elektronikmodule zu einem auslieferbaren System ist in vorteilhafter Weise automatisierbar. Nach dem Abschluss des Montagevorgangs der Elektronikmodule beim Hersteller bildet das erfindungsgemäße System eine stabile versandfertige Einheit, die auf einfache Weise an einer Tragschiene, die zum Beispiel innerhalb eines Schaltschranks angeordnet sein kann. montiert werden kann. Die Verbindung der Elektronikmodule untereinander ist so stabil, dass das gesamte Handling des Systems von der Vormontage beim Hersteller bis zur Endmontage an der Tragschiene ohne die Verwendung einer zusätzlichen Tragstruktur zum Halten der Elektronikmodule erfolgen kann. Das bereits beim Hersteller vorkonfigurierte System kann somit ohne eine Zerlegung in die einzelnen Elektronikmodule als Einheit an der Tragschiene befestigt werden. Nach der Montage des Systems an der Tragschiene ist es darüber hinaus in vorteilhafter Weise möglich, einzelne Elektronikmodule wieder zu demontieren, ohne dabei das gesamte System von der Tragschiene entfernen zu müssen. Dabei werden die beiden Rastschieber des aus dem System zu entfernenden Elektronikmoduls nach außen verschoben und in eine Entriegelungsstellung überführt, in der sie das Tragschienengehäuse nicht mehr an der Tragschiene verriegeln. Die Busverbinder eines oder mehrerer benachbarter Elektronikmodule werden dabei weiterhin von diesen gehalten.

Vorzugsweise kann eines der Elektronikmodule ein Abschlussmodul des Systems bilden und einen Terminierungsstecker aufweisen. Der Terminierungsstecker, der mit Stiftkontakten des Stiftkontaktelements des betreffenden Elektronikmoduls verbindbar ist, kann mit oder ohne elektrische Funktion ausgeführt sein.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen:
- Fig. 1: eine Seitenansicht eines Elektronikmoduls mit einem Tragschienengehäuse, das gemäß einem bevorzugten Ausführungsbeispiel der vorliegenden Erfindung ausgeführt ist, vor der Montage eines Busverbinders an dem Tragschienengehäuse,
- Fig. 2: eine Draufsicht auf das Elektronikmodul gemäß Fig. 1,
- Fig. 3: eine perspektivische Ansicht eines Rastschiebers, der an einer Montageseite des Tragschienengehäuses anbringbar ist,
- Fig. 4: eine perspektivische Ansicht des Busverbinders,
- Fig. 5: eine perspektivische Ansicht eines Steckkontaktelements,
- Fig. 6: eine perspektivische, auseinandergezogene Detailansicht, die Einzelheiten der Anbringung des Rastschiebers an der Montageseite des Tragschienengehäuses veranschaulicht,
- Fig. 7: eine perspektivische Detailansicht, die den Rastschieber nach der Montage an dem Tragschienengehäuse zeigt,
- Fig. 8: eine perspektivische Ansicht des Tragschienengehäuses nach der Montage der Rastschieber, von einer Montageseite aus betrachtet,
- Fig. 9a: eine perspektivische Ansicht, die den Busverbinder während der Montage an dem Tragschienengehäuse zeigt,
- Fig. 9b: eine Seitenansicht des Elektronikmoduls während der Montage des Busverbinders,
- Fig. 9c: eine weitere perspektivische Ansicht, die den Busverbinder während der Montage an dem Tragschienengehäuse zeigt,
- Fig. 10a: eine Seitenansicht des Elektronikmoduls nach der Montage des Busverbinders,
- Fig. 10b: eine weitere perspektivische Ansicht, die den Busverbinder nach der Montage an dem Tragschienengehäuse zeigt,
- Fig. 11: eine Draufsicht auf das Elektronikmodul gemäß Fig. 10a,
- Fig. 12: eine Seitenansicht eines Systems, insbesondere eines Steuerungssystems, mit mehreren Elektronikmodulen während der Montage eines zweiten Elektronikmoduls an einem ersten Elektronikmodul,
- Fig. 13: einen Schnitt durch das System gemäß Fig. 12,
- Fig. 14: eine weitere Seitenansicht des Systems gemäß Fig. 12 während der Montage des zweiten Elektronikmoduls,
- Fig. 15: eine Draufsicht auf das System nach der Montage des zweiten Elektronikmoduls,
- Fig. 16: eine Seitenansicht des Systems nach der Montage eines dritten Elektronikmoduls,
- Fig. 17: eine Draufsicht auf das System gemäß Fig. 16,
- Fig. 18: eine Seitenansicht des Systems gemäß Fig. 16 vor der Montage an einer Tragschiene,
- Fig. 19: eine Draufsicht auf das System gemäß Fig. 16 vor der Montage an der Tragschiene,
- Fig. 20: eine Seitenansicht des Systems gemäß Fig. 16 während der Montage an der Tragschiene,
- Fig. 21: eine Draufsicht auf das System gemäß Fig. 16 während der Montage an der Tragschiene,
- Fig. 22: eine Seitenansicht des Systems gemäß Fig. 16 nach der Montage an der Tragschiene,
- Fig. 23: eine Draufsicht auf das System gemäß Fig. 16 nach der Montage an der Tragschiene,
- Fig. 24: eine Vorderansicht des Systems vor einer Demontage eines der Elektronikmodule von der Tragschiene,
- Fig. 25: eine Draufsicht auf das System gemäß Fig. 24 während der Demontage eines der Elektronikmodule,
- Fig. 26: eine Vorderansicht des Systems nach der Demontage des Elektronikmoduls.

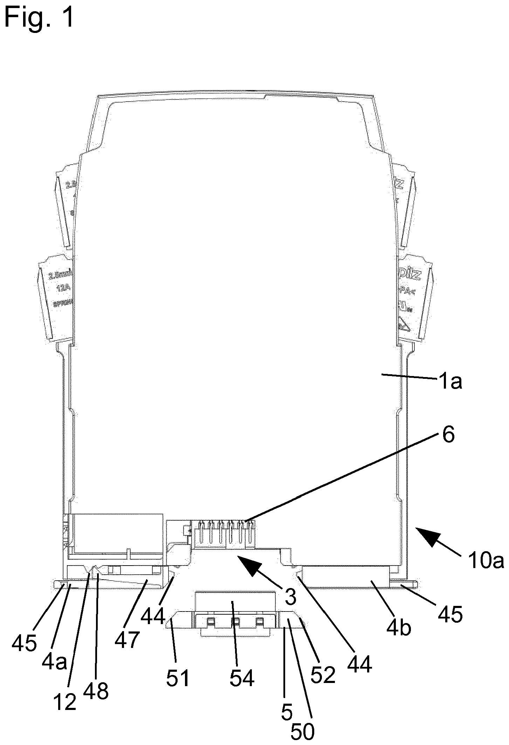

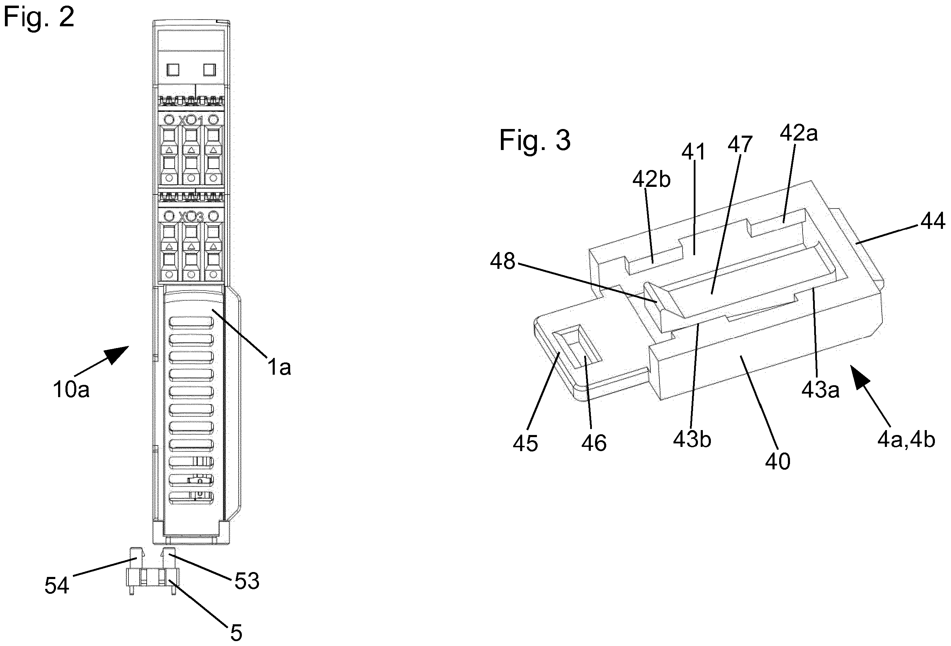

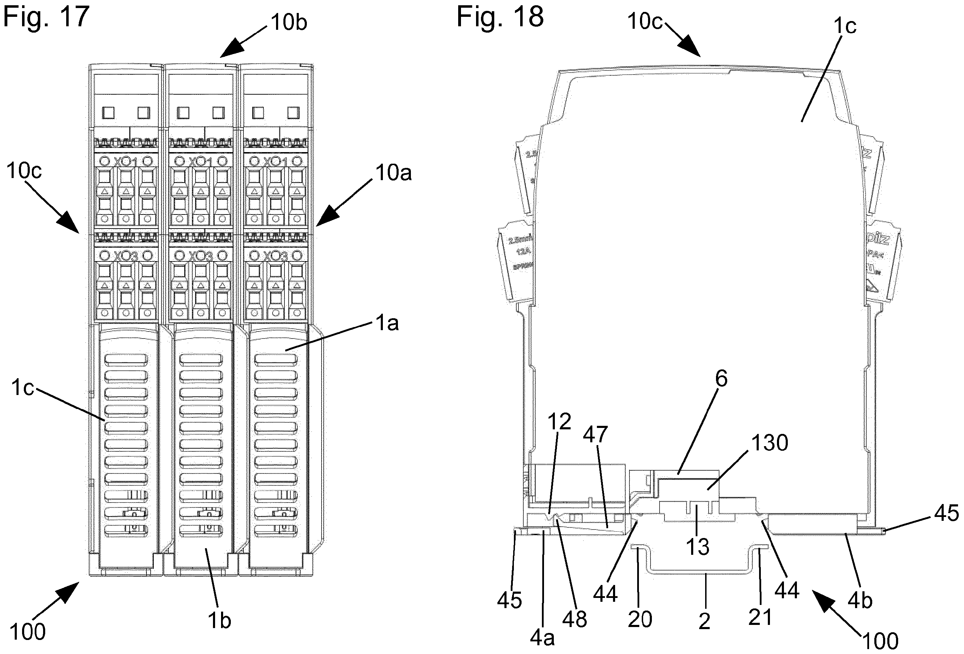

Unter Bezugnahme auf Fig. 1 und 2 ist dort ein Elektronikmodul 10a mit einem Tragschienengehäuse 1a gezeigt, welches gemäß einem bevorzugten Ausführungsbeispiel der vorliegenden Erfindung ausgeführt ist. Das Tragschienengehäuse 1a ist so ausgebildet, dass es an einer Tragschiene 2, die - wie zum Beispiel in Fig. 18 zu erkennen - vorzugsweise eine Hutschiene mit einer Hutprofilform ist, angebracht und mit dieser verrastet werden kann. Das Tragschienengehäuse 1a weist zu diesem Zweck eine Tragschienenaufnahmeöffnung 3 auf, die so geformt und dimensioniert ist, dass die Tragschiene 2 bei der Montage des Tragschienengehäuses 1a abschnittsweise darin aufgenommen und verrastet werden kann. Um das Tragschienengehäuse 1a an der Tragschiene 2 rastend festlegen zu können, sind an einer der Tragschiene 2 bei der Montage zugewandten Gehäuseseite des Tragschienengehäuses 1a, welche nachfolgend auch als Montageseite bezeichnet werden soll, zwei Rastschieber 4a, 4b angebracht, die relativ zum Tragschienengehäuse 1a verschiebbar geführt sind. Um Einzelheiten des in Fig. 1 auf der linken Seite dargestellten Rastschiebers 4a zu verdeutlichen, wurde ein Teil dieses Rastschiebers 4a in der Darstellung gemäß Fig. 1 und auch in weiteren Figuren ganz bewusst weggeschnitten.

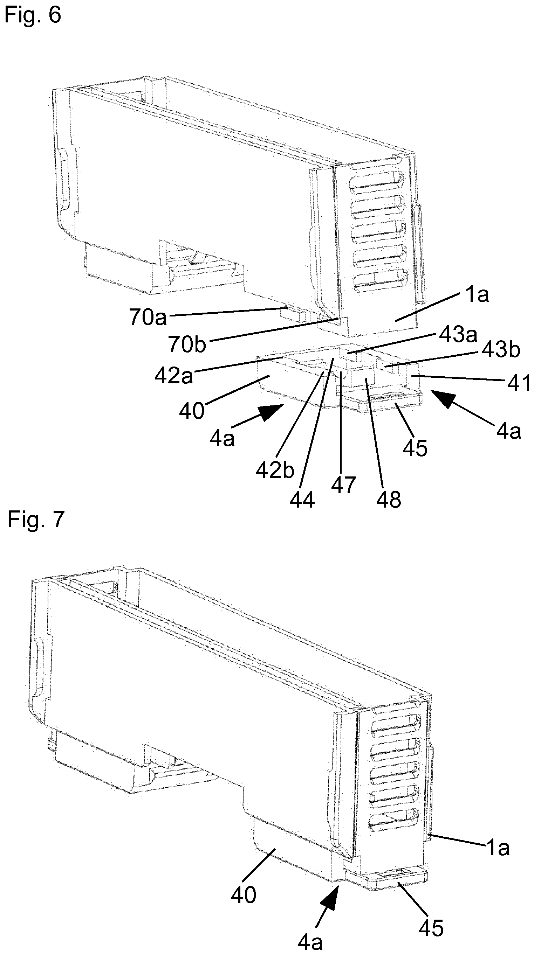

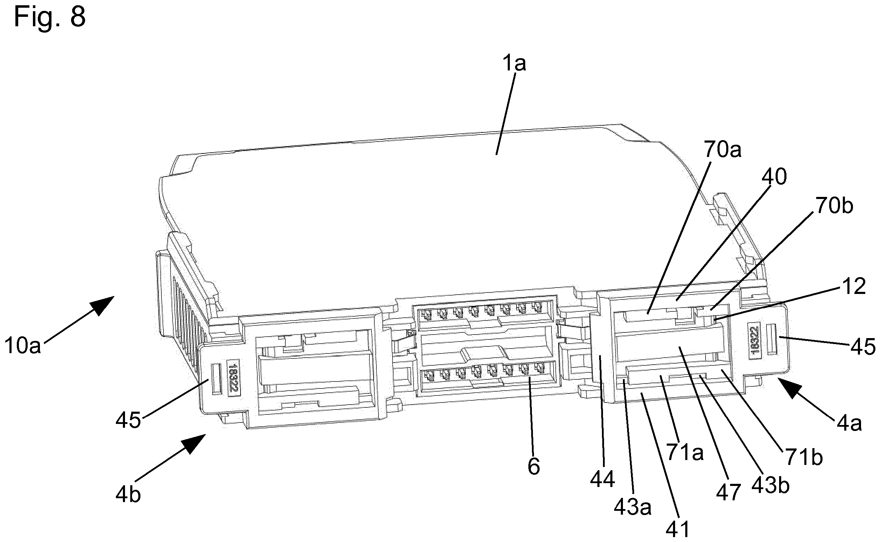

Unter Bezugnahme auf Fig. 3 und 6 bis 8 sollen nachfolgend konstruktive Einzelheiten dieser beiden Rastschieber 4a, 4b näher erläutert werden. Beide Rastschieber 4a, 4b sind identisch ausgeführt und weisen - wie insbesondere in der perspektivischen Ansicht gemäß Fig. 3 sowie in der Detailansicht gemäß Fig. 6 zu erkennen - in diesem Ausführungsbeispiel an jeder ihrer beiden Längsseiten 40, 41 zwei sich nach innen erstreckende Haltevorsprünge 42a, 42b, 43a, 43b auf. Das Tragschienengehäuse 1a weist an den beiden einander gegenüberliegenden Ende der Montageseite für jeden dieser beiden Rastschieber 4a, 4b jeweils vier mit den Haltevorsprüngen 42a, 42b, 43a, 43b des betreffenden Rastschiebers 4a, 4b korrespondierende Führungen 70a, 70b, 71a, 71b auf. Diese Führungen 70a, 70b, 71a, 71b sind so geformt und dimensioniert, dass jeweils einer der Haltevorsprünge 42a, 42b, 43a, 43b in einer der Führungen 70a, 70b, 71a, 71b aufgenommen werden kann. Dadurch wird erreicht, dass die Rastschieber 4a, 4b in den Führungen 70a, 70b, 71a, 71b verschiebbar geführt sind. Die Mittel, welche die Führung der Rastschieber 4a, 4b bewirken, können auch in anderer Weise ausgestaltet sein.

Jeder der beiden Rastschieber 4a, 4b weist ferner ein erstes Ende auf, das sich in der Montagesolllage des betreffenden Rastschiebers 4a, 4b abschnittsweise in die Tragschienenaufnahmeöffnung 3 des Tragschienengehäuses 1a hinein erstreckt und einen Halteabschnitt 44 des Rastschiebers 4a, 4b bildet. An einem zweiten Ende der beiden Rastschieber 4a, 4b, welches dem ersten Ende gegenüberliegt, ist jeweils ein Handhabungsabschnitt 45 mit einer Eingriffsöffnung 46 ausgebildet. An einem zum zweiten Ende und damit zum Handhabungsabschnitt 45 weisenden Bereich des Halteabschnitts 44 ist ferner ein Biegebalken 47 ausgebildet, der sich in Längsrichtung zwischen den beiden Längsseiten 40, 41 des Rastschiebers 4a, 4b erstreckt und an seinem freien Ende einen zur Montageseite des Tragschienengehäuses 1a weisenden Rastvorsprung 48 umfasst.

An der Montageseite des Tragschienengehäuses 1a sind zwei Rastaufnahmen 12 (oder in einer alternativen Ausgestaltung Widerlager) ausgebildet, die jeweils einem der beiden Rastschieber 4a, 4b zugeordnet sind. In Fig. 1 ist eine dieser beiden Rastaufnahmen 12, welche dem Rastschieber 4a auf der linken Seite zugeordnet ist, zu erkennen. Jede der beiden Rastaufnahmen 12 ist derart an der Montageseite des Tragschienengehäuses 1a angeordnet und so geformt, dass diese mit dem Rastvorsprung 48 des Biegebalkens 47 des der betreffenden Rastaufnahme 12 zugeordneten Rastschiebers 4a, 4b zusammenwirken kann. Durch den Eingriff der Rastvorsprünge 48 in die zugehörigen Rastaufnahmen 12 können die Rastschieber 4a, 4b in einer Verriegelungsstellung an der Montageseite des Tragschienengehäuses 1a rastend festgelegt werden. Die Biegebalken 47 der Rastschieber 4a, 4b bringen in der Rastposition der Rastschieber 4a, 4b eine entsprechende Haltekraft auf, so dass die Rastvorsprünge 48 in den Rastaufnahmen 12 gehalten werden können. Weitere Einzelheiten der Funktion der beiden Rastschieber 4a, 4b werden weiter unten noch näher erläutert.

Innerhalb des Tragschienengehäuses 1a ist zumindest eine Leiterplatte mit elektronischen und/oder elektromechanischen Bauteilen untergebracht, die dem Elektronikmodul 10a bestimmte Funktionen zur Verfügung zu stellen. Beispiele für derartige Elektronikmodule 10a, 10b, 10c, aus denen das System 100 aufgebaut werden kann, sind unter anderem Steuerungsmodule, Schnittstellenmodule, Feldbuscontroller, Feldbuskoppler, Eingangsmodule, die Eingangssignale eines oder mehrerer Sensoren empfangen und gegebenenfalls verarbeiten können, Ausgangsmodule, die Ausgangssignale an einen oder mehrere daran angeschlossene Aktoren ausgeben können, oder kombinierte Eingangs- und Ausgangsmodule (so genannte I/O-Module). Aus mehreren Elektronikmodulen 10a, 10b, 10c kann ein System 100, insbesondere ein Steuerungssystem, modular aufgebaut werden. Der modulare Aufbau des Systems 100 schafft in besonders vorteilhafter Weise die Möglichkeit einer anwendungsspezifischen Konfiguration, indem mehrere Elektronikmodule 10a, 10b, 10c individuell zusammengestellt werden können, um dadurch dem System 100 die gewünschten Funktionalitäten zur Verfügung zu stellen.

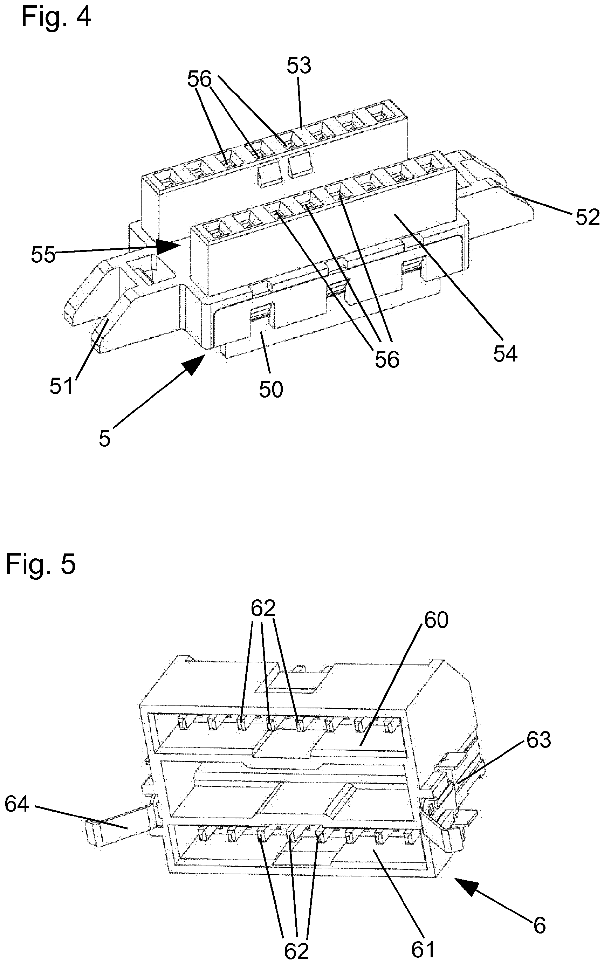

Um ein erstes Elektronikmodul 10a mit einem zweiten Elektronikmodul 10b, dessen mechanischer Aufbau mit demjenigen des ersten Elektronikmoduls 10a identisch ist, in zuverlässiger Weise elektrisch und darüber hinaus auch mechanisch verbinden zu können, ist das erste Tragschienengehäuse 1a mit einem Busverbinder 5 sowie mit einem Steckkontaktelement 6 ausgestattet, die in Fig. 4 und Fig. 5 im Detail gezeigt sind. Wie in Fig. 5 zu erkennen, weist das Steckkontaktelement 6, das innerhalb des ersten Tragschienengehäuses 1a untergebracht ist, zwei Steckkontaktreihen 60, 61 mit einer Anzahl von Steckkontakten 62 auf, die in Richtung der Tragschienenaufnahmeöffnung 3 weisen. Vorliegend sind in jeder der beiden Steckkontaktreihen 60, 61 insgesamt acht Steckkontakte 62 vorgesehen. An jeder der beiden einander gegenüberliegenden Stirnseiten des Steckkontaktelements 6 ist überdies eine Erdungsfeder 63, 64 angebracht. Ein entsprechend ausgeführtes Steckkontaktelement 6 ist auch innerhalb des Tragschienengehäuses 1b des zweiten Elektronikmoduls 10b untergebracht.

Der Busverbinder 5, der in Fig. 4 dargestellt ist und die Steckkontaktelemente 6 der beiden benachbarten Elektronikmodule 10a, 10b miteinander verbindet, umfasst einen Grundkörper 50 mit zwei einander gegenüberliegenden Enden, an denen jeweils eine Schrägfläche 51, 52 ausgebildet ist. Ferner umfasst der Busverbinder 5 zwei Anschlussbuchsenreihen 53, 54, die sich parallel zueinander erstrecken und durch einen Zwischenraum 55 voneinander beabstandet sind. Jede der beiden Anschlussbuchsenreihen 53, 54 weist vorliegend acht Anschlussbuchsen 56 auf. Mit anderen Worten entspricht also die Anzahl der Anschlussbuchsen 56 in jeder der beiden Anschlussbuchsenreihen 53, 54 der Anzahl der Steckkontakte 62 in den beiden Steckkontaktreihen 60, 61 des Steckkontaktelements 6.

Um die Tragschienengehäuse 1a, 1b zweier benachbarter Elektronikmodule 10a, 10b miteinander zu verbinden, werden die Steckkontakte 62 einer ersten Steckkontaktreihe 60 des Steckkontaktelements 6 des ersten Tragschienengehäuses 1a in die Anschlussbuchsen 56 der ersten Anschlussbuchsenreihe 53 des Busverbinders 5 eingesteckt. Ferner werden die Steckkontakte 62 einer zweiten Steckkontaktreihe 61 des Steckkontaktelements 6 des zweiten Tragschienengehäuses 1b in die Anschlussbuchsen 62 der zweiten Anschlussbuchsenreihe 54 des Busverbinders 5 eingesteckt. Der Busverbinder 5 ermöglicht insbesondere eine Datenkommunikation zwischen den beiden benachbart zueinander angeordneten Elektronikmodulen 10a, 10b.

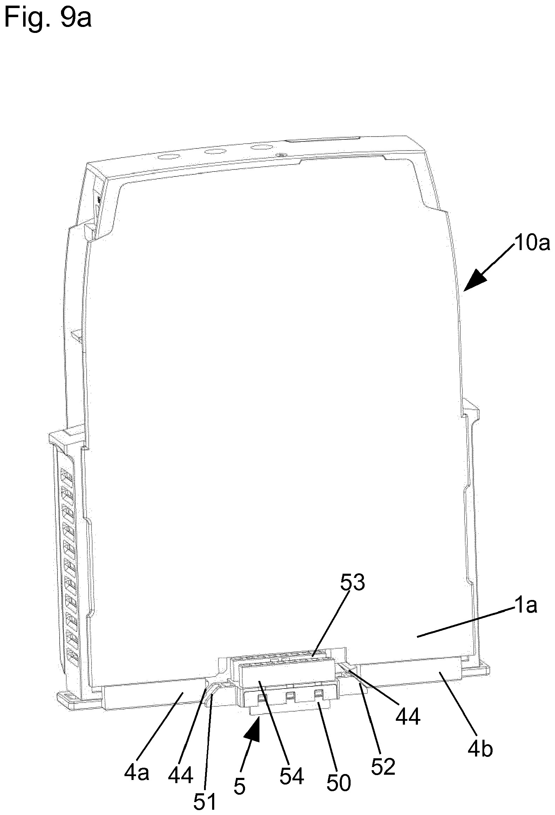

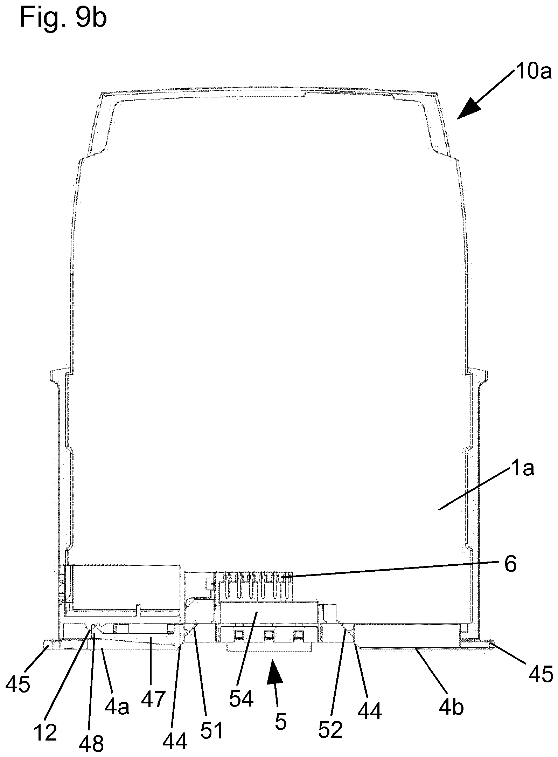

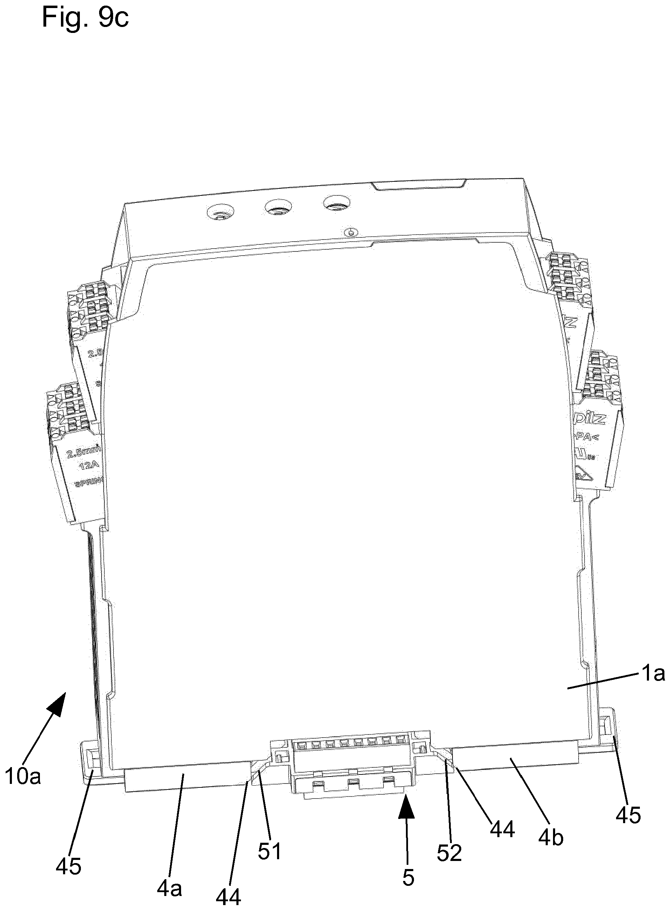

Unter Bezugnahme auf Fig. 1, 9a bis 11 sollen nachfolgend Einzelheiten der Montage des Busverbinders 5 und der mechanischen Verbindung des Busverbinders 5 mit dem Tragschienengehäuse 1a des ersten Elektronikmoduls 10a näher erläutert werden. Wie in Fig. 1 und 9a zu erkennen, wird der Busverbinder 5 von der Tragschienenseite in die Tragschienenaufnahmeöffnung 3 des betreffenden Tragschienengehäuses 1a eingesetzt. Aus Fig. 9b und 9c ergibt sich, dass während des Montageprozesses jede der beiden äußeren Schrägflächen 51, 52 des Busverbinders 5 jeweils gegen den Halteabschnitt 44 eines der beiden Rastschieber 4a, 4b drückt. Dadurch werden die Rastschieber 4a, 4b in axialer Richtung nach außen verschoben und weichen dem Busverbinder 5 aus und geben somit den Weg für den Busverbinder 5 frei. Diese Situation ist in Fig. 9b und 9c zu erkennen.

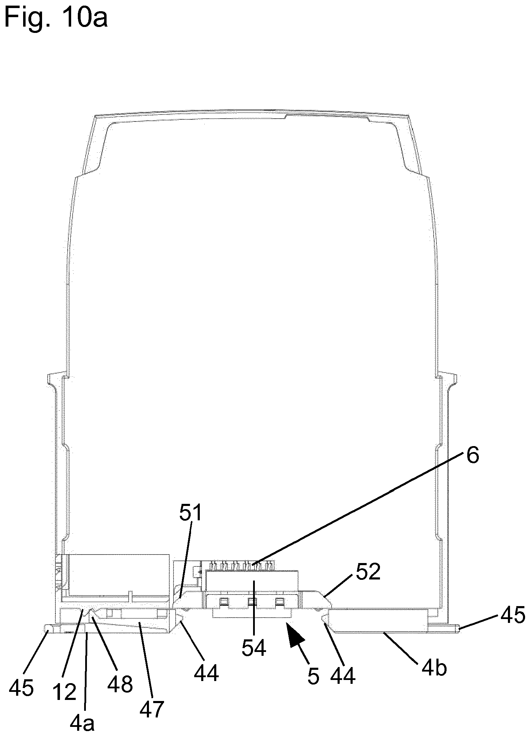

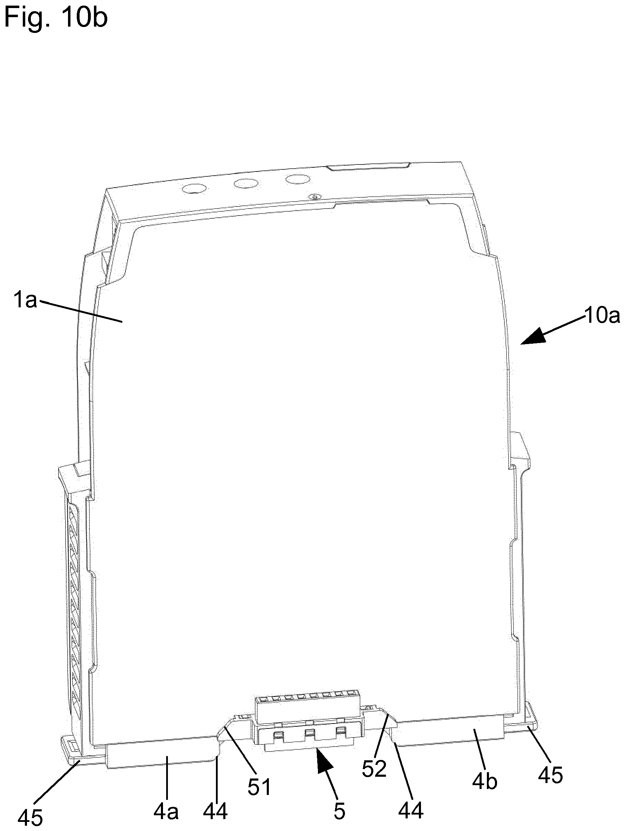

Mit dieser Verschiebebewegung der beiden Rastschieber 4a, 4b nach außen geht darüber hinaus auch eine leichte Verbiegung der Biegebalken 47 einher, bei der die Rastvorsprünge 48 fest in die Rastaufnahmen 12 an der Montageseite des Tragschienengehäuses 1 gedrückt werden und dabei weiterhin mit diesen in Eingriff stehen. Diese Verbiegung der Biegebalken 47 der beiden Rastschieber 4a, 4b erzeugt eine Rückstellkraft, die in Richtung der Tragschienenaufnahmeöffnung 3 wirkt. Sobald der Busverbinder 5 die beiden Rastschieber 4a, 4b passiert hat und sich in seiner Montagesolllage befindet, in der die Steckkontakte 62 der ersten Steckkontaktreihe 60 des Steckkontaktelements 6 in die Anschlussbuchsen 56 der ersten Anschlussbuchsenreihe 53 des Busverbinders 5 eingesteckt sind, bewegen sich die Rastschieber 4a, 4b durch die auf sie einwirkende Rückstellkraft selbsttätig wieder in Richtung der Tragschienenaufnahmeöffnung 3. Wie in Fig. 10a und 10b zu erkennen, erstrecken sich die Halteabschnitte 44 an den freien Enden der Rastschieber 4a, 4b in der Montagesolllage des Busverbinders 5 derart über die freien Enden des Busverbinders 5 hinweg, dass der Busverbinder 5 mittels der beiden Rastschieber 4a, 4b in seiner Montagesolllage fixiert ist. Dadurch wird erreicht, dass der Busverbinder 5 unverlierbar mit dem betreffenden Tragschienengehäuse 1a verbunden ist. Die Montage des Busverbinders 5 an dem Tragschienengehäuse 1a kann zum Beispiel automatisiert in einer Montagestation erfolgen.

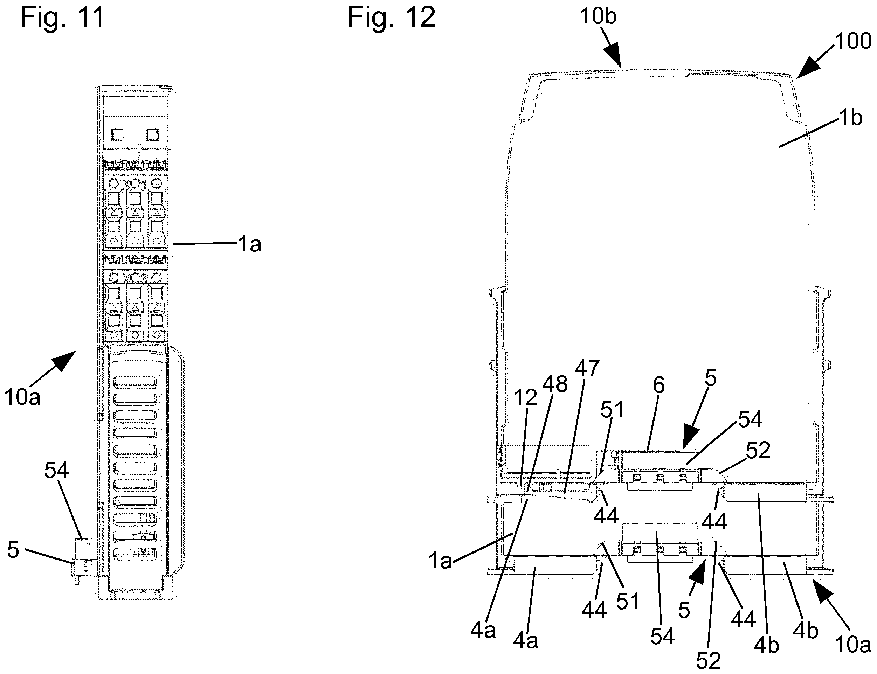

Unter Bezugnahme auf Fig. 12 bis 17 soll nachfolgend der Aufbau eines Systems 100, insbesondere eines Steuerungssystems, welches insgesamt drei Elektronikmodule 10a, 10b, 10c umfasst, näher erläutert werden. In einem ersten Montageschritt, der in Fig.12 bis 15 dargestellt ist, wird ein zweites Elektronikmodul 10b mit einem ersten Elektronikmodul 10a elektrisch und mechanisch verbunden. Beide Elektronikmodule 10a, 10b sind mit einem Steckkontaktelement 6 der oben beschriebenen Art sowie mit einem Busverbinder 5 ausgestattet, der in der vorstehend erläuterten Weise an den Tragschienengehäusen 1a, 1b der Elektronikmodule 10a, 10b montiert ist und mit Hilfe der Rastschieber 4a, 4b der betreffenden Tragschienengehäuse 1a, 1b in seiner Montagesolllage gehalten wird. Die Steckkontaktelemente 6 und die Busverbinder 5 können insbesondere nach dem CAN-Bus-Standard ausgeführt sein. Überdies kann über die Steckverbindungen auch eine elektrische Versorgungsspannung vom ersten Elektronikmodul 10a zum zweiten Elektronikmodul 10b und von diesem auch zum dritten Elektronikmodul 10c (und gegebenenfalls weiteren Elektronikmodulen) für deren Betrieb übertragen werden. Ferner ist es auch denkbar, dass über diese Steckverbindungen elektrische Versorgungsspannungen für den Betrieb der an die Elektronikmodule 10b, 10c angeschlossenen Sensoren und/oder Aktoren bereitgestellt werden, die durch entsprechende Anschlussstecker an den Elektronikmodulen 10b, 10c abgegriffen werden können.

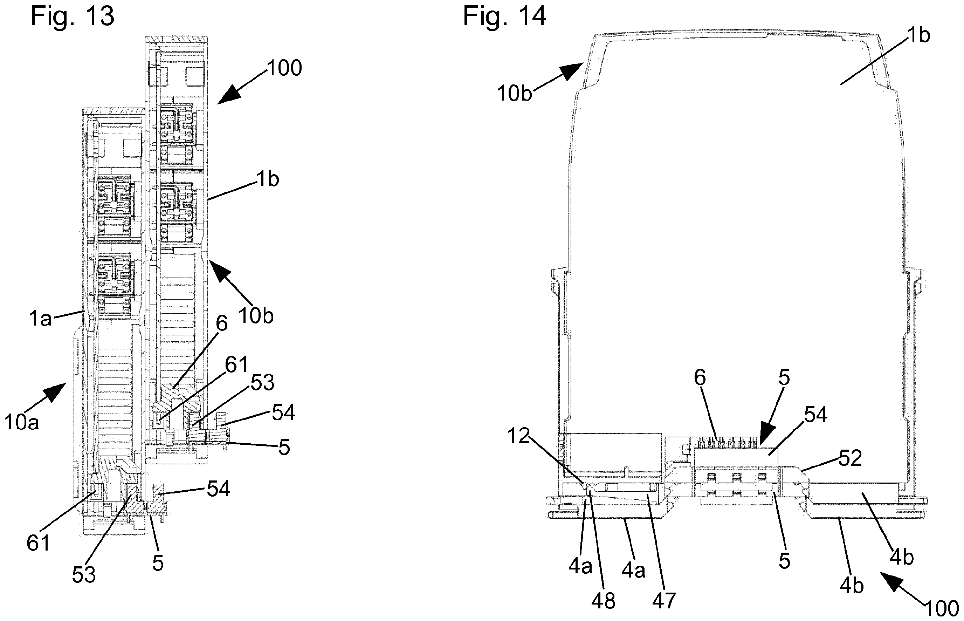

Bei der Montage des zweiten Elektronikmoduls 10b wird dessen Tragschienengehäuse 1b an dem Tragschienengehäuse 1a des ersten Elektronikmoduls 10a angesetzt und derart verschoben, bis der Busverbinder 5 des ersten Elektronikmoduls 10a in der Tragschienenaufnahmeöffnung 3 des Tragschienengehäuses 1b des zweiten Elektronikmoduls 10b einrastet. Während des Montageprozesses drückt jede der beiden äußeren Schrägflächen 51, 52 des Busverbinders 5, der am Tragschienengehäuse 1a des ersten Elektronikmoduls 10a festgelegt ist, jeweils gegen einen der Halteabschnitte 44 der beiden Rastschieber 4a, 4b des Tragschienengehäuses 1b des zweiten Elektronikmoduls 10b. Dadurch werden die Rastschieber 4a, 4b des Tragschienengehäuses 1b des zweiten Elektronikmoduls 10b in axialer Richtung nach außen verschoben und weichen dabei dem Busverbinder 5 aus und ermöglichen dadurch, dass die Steckkontakte 62 der zweiten Steckkontaktreihe 61 des Steckkontaktelements 6 des zweiten Tragschienengehäuses 1b in die Anschlussbuchsen 62 der zweiten Anschlussbuchsenreihe 54 des Busverbinders 5 des Tragschienengehäuses 1a des ersten Elektronikmoduls 10a eingesteckt werden können. Diese Situation ist in Fig. 14 dargestellt. Mit dieser Verschiebebewegung der beiden Rastschieber 4a, 4b des Tragschienengehäuses 1b des zweiten Elektronikmoduls 10b nach außen geht darüber hinaus wiederum eine leichte Verbiegung der Biegebalken 47 einher, durch die die Rastvorsprünge 48 fest in die Rastaufnahmen 12 auf der Montageseite des Tragschienengehäuses 1b des zweiten Elektronikmoduls 10b gedrückt werden, aber weiterhin mit diesen in Eingriff stehen. Diese Verbiegung der Biegebalken 47 der beiden Rastschieber 4a, 4b erzeugt wiederum eine Rückstellkraft, die in Richtung der Tragschienenaufnahmeöffnung 3 des Tragschienengehäuses 1b des zweiten Elektronikmoduls 10b wirkt.

Wenn sich das Tragschienengehäuse 1b des zweiten Elektronikmoduls 10b in seiner Montagesolllage befindet, in der der Busverbinder 5 des ersten Elektronikmoduls 10a die beiden Rastschieber 4a, 4b des zweiten Elektronikmoduls 10b passiert hat und die Steckkontakte 62 der zweiten Steckkontaktreihe 61 des Steckkontaktelements 6 des zweiten Elektronikmoduls 10b in die Anschlussbuchsen 56 der zweiten Anschlussbuchsenreihe 54 des Busverbinders 5 des ersten Elektronikmoduls 10a eingesteckt sind, bewegen sich die Rastschieber 4a, 4b des zweiten Elektronikmoduls 10b durch die auf sie einwirkende Rückstellkraft wieder in Richtung der Tragschienenaufnahmeöffnung 3. Die Halteabschnitte 44 an den freien Enden der Rastschieber 4a, 4b des zweiten Elektronikmoduls 10b erstrecken sich derart über die freien Enden des Busverbinders 5 des ersten Elektronikmoduls 10a hinweg, dass der Busverbinder 5 des ersten Elektronikmoduls 10a auch mittels der beiden Rastschieber 4a, 4b des zweiten Elektronikmoduls 10b in seiner Montagesolllage fixiert wird. Die Biegebalken 47 der Rastschieber 4a, 4b beider Elektronikmodule 10a, 10b bringen in der Verriegelungsstellung nur die Haltekraft auf.

In analoger Weise kann ein drittes Elektronikmodul 10c an dem zweiten Elektronikmodul 10b montiert werden, um ein System 100, insbesondere ein Steuerungssystem, wie es in Fig. 17 und 18 gezeigt ist, zu erhalten. Das dritte Elektronikmodul 10c bildet vorliegend ein Abschlussmodul des Systems 100 und weist daher keinen Busverbinder 5 zum Anschluss eines weiteren Elektronikmoduls auf. Stattdessen weist das dritte Elektronikmodul 10c einen Terminierungsstecker 13 auf, der in der Tragschienenaufnahmeöffnung 3 des Tragschienengehäuses 1c des dritten Elektronikmoduls 10c montiert werden kann. Konstruktiv unterscheidet sich der Terminierungsstecker 13 von den Busverbindern 5 unter anderem dadurch, dass er lediglich eine Anschlussbuchsenreihe 130 aufweist. Grundsätzlich ist es möglich, den Terminierungsstecker 13 mit oder ohne elektrische Funktion auszuführen. Nach der Montage wird der Terminierungssteckers 13 mittels der Rastschieber 4a, 4b des dritten Elektronikmoduls 10c gesichert und vorzugsweise ebenfalls unverlierbar in der Tragschienenaufnahmeöffnung 3 gehalten.

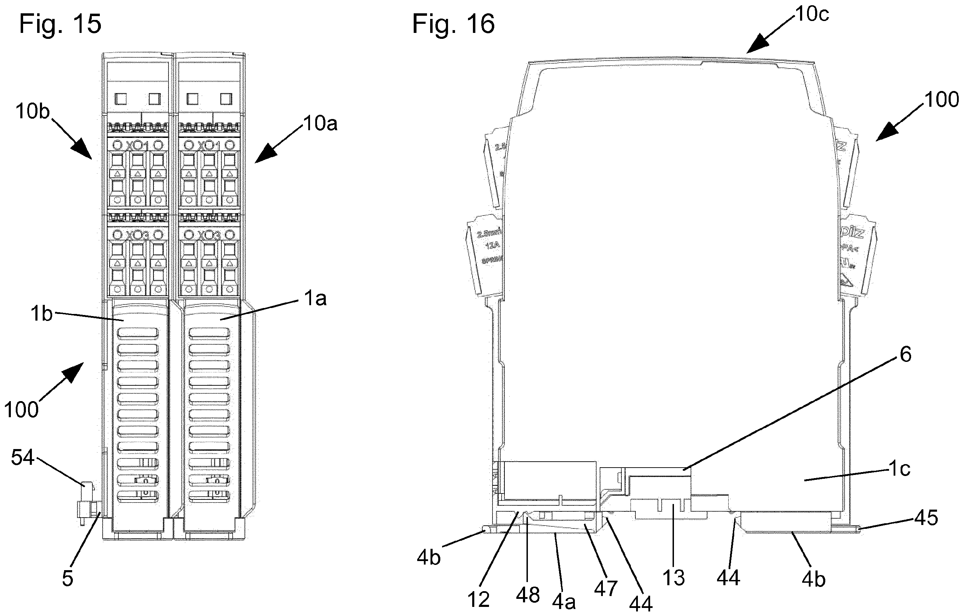

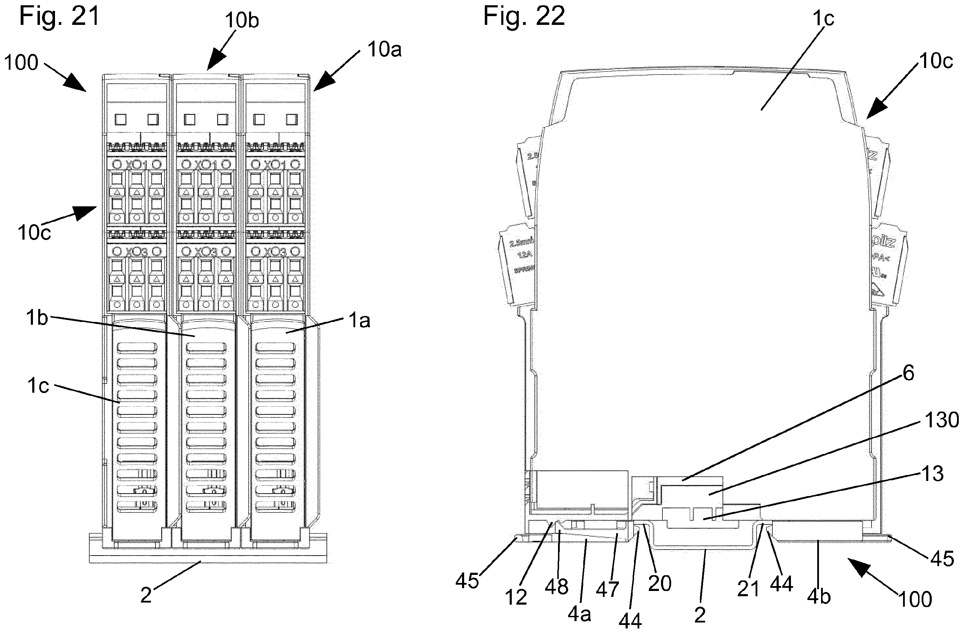

Die Zusammenstellung der einzelnen Elektronikmodule 10a, 10b, 10c zu einem auslieferbaren System 100 ist in vorteilhafter Weise automatisierbar. Nach dem Abschluss des Montagevorgangs der drei Elektronikmodule 10a, 10b, 10c bildet das in Fig. 16 und 17 gezeigte System 100 eine stabile versandfertige Einheit, die auf einfache Weise an einer Tragschiene 2 montiert werden kann. Die elektrischen und mechanischen Verbindung der Elektronikmodule 10a, 10b, 10c untereinander sind so stabil, dass das gesamte Handling des Systems 100 von der Vormontage beim Hersteller bis zur Endmontage an der Tragschiene 2 ohne die Verwendung einer zusätzlichen Tragstruktur zum Halten der Elektronikmodule 10a, 10b, 10c möglich ist. Das bereits beim Hersteller vorkonfigurierte System 100 kann somit ohne eine Zerlegung in die einzelnen Elektronikmodule 10a, 10b, 10c als vormontierte und vorkonfigurierte Einheit an der Tragschiene 2 angebracht werden. Einzelheiten des Montageprozesses des Systems 100 an der Tragschiene 2 sollen nachfolgend unter Bezugnahme auf Fig. 18 bis 23 näher erläutert werden.

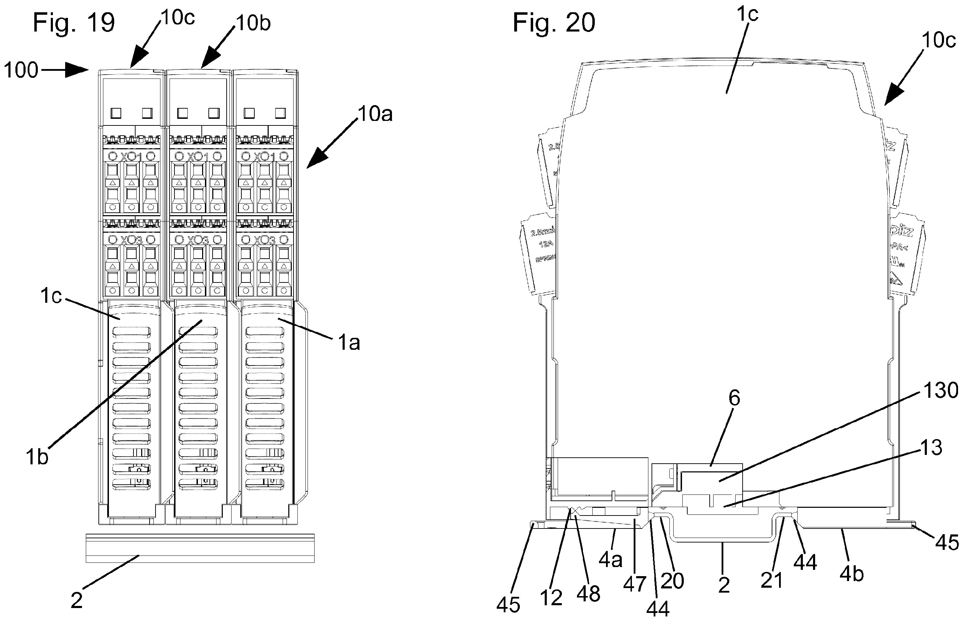

Die Tragschiene 2 ist vorliegend eine Hutprofilschiene und weist zwei nach außen umgebogene, sich in Längsrichtung der Tragschiene 2 erstreckende Halteabschnitte 20, 21 auf, die bei der Montage des Systems 100 in die Tragschienenaufnahmeöffnungen 3 der Tragschienengehäuse 1a, 1b, 1c der Elektronikmodule 10a, 10b, 10c eingreifen können und darin festgelegt werden können. Das System 100 kann dabei in einem einzigen Schritt an der Hutschiene 2 montiert werden. Beim Einsetzen der Halteschenkel 20, 21 in die Tragschienenaufnahmeöffnungen 3 der Tragschienengehäuse 1a, 1b, 1c greifen die Halteschenkel 20, 21 mit ihren freien Enden an den Halteabschnitten 44 der Rastschieber 4a, 4b der Tragschienengehäuse 1a, 1b, 1c an. Dadurch werden die Rastschieber 4a, 4b aller Tragschienengehäuse 1a, 1b, 1c in axialer Richtung nach außen verschoben und weichen den Halteschenkeln 20, 21 der Hutschiene 2 aus. Diese Situation ist in Fig. 20 dargestellt. Mit dieser Verschiebebewegung der Rastschieber 4a, 4b der Tragschienengehäuse 1a, 1b, 1c nach außen geht darüber hinaus eine leichte Verbiegung der Biegebalken 47 sämtlicher Rastschieber 4a, 4b einher, bei der die Rastvorsprünge 48 der Biegebalken 47 fest in die Rastaufnahmen 12 auf der Montageseite der Tragschienengehäuse 1a, 1b, 1c gedrückt werden, aber weiterhin mit diesen in Eingriff stehen. Diese Verbiegung der Biegebalken 47 der Rastschieber 4a, 4b erzeugt eine Rückstellkraft, die in Richtung der Tragschienenaufnahmeöffnung 3 der Tragschienengehäuse 1a, 1b, 1c der Elektronikmodule 10a, 10b, 10c wirkt. Wenn die Halteschenkel 20, 21 der Tragschiene 2 die Rastschieber 4a, 4b der Tragschienengehäuse 1a, 1b, 1c passiert haben, bewegen sich die

Rastschieber 4a, 4b durch die auf sie einwirkende Rückstellkraft wieder in Richtung der Tragschienenaufnahmeöffnungen 3 der Tragschienengehäuse 1a, 1b, 1c. Die Halteschenkel 20, 21 erstrecken sich in der Montagesolllage der Tragschiene 2 somit zwischen den Halteabschnitten 44 der Rastschieber 4a, 4b des ersten und zweiten Elektronikmoduls 10a, 10b und den Busverbindern 5 des ersten und zweiten Elektronikmoduls 10a, 10b beziehungsweise zwischen den Halteabschnitten 44 der Rastschieber 4a, 4b und dem Terminierungsstecker 13 des dritten Elektronikmoduls 10c. Auf diese Weise wird das System 100 rastend an der Tragschiene 2 festgelegt. In der Montagesolllage, in der die Biegebalken 47 der Rastschieber 4a, 4b nur ihre Haltekraft aufbringen, kontaktieren die Erdungsfedern 63, 64 der Steckkontaktelemente 6 aller Elektronikmodule 10a, 10b, 10c überdies die Halteschenkel 20, 21 der Tragschiene 2.

Alternativ zu dem vorstehend erläuterten Montageprozess kann das System 100 auch einseitig auf die Tragschiene 2 aufgesetzt und dann eingeschwenkt werden, um dadurch die Halteschenkel 20, 21 der Tragschiene 2 in ihre Montagesolllage zu überführen, in der sie sich zwischen den Halteabschnitten 44 der Rastschieber 4a, 4b und den Busverbindern 5 des ersten und zweiten Elektronikmoduls 10a, 10b beziehungsweise zwischen den Halteabschnitten 44 der Rastschieber 4a, 4b und dem Terminierungsstecker 13 des dritten Elektronikmoduls 10c erstrecken.

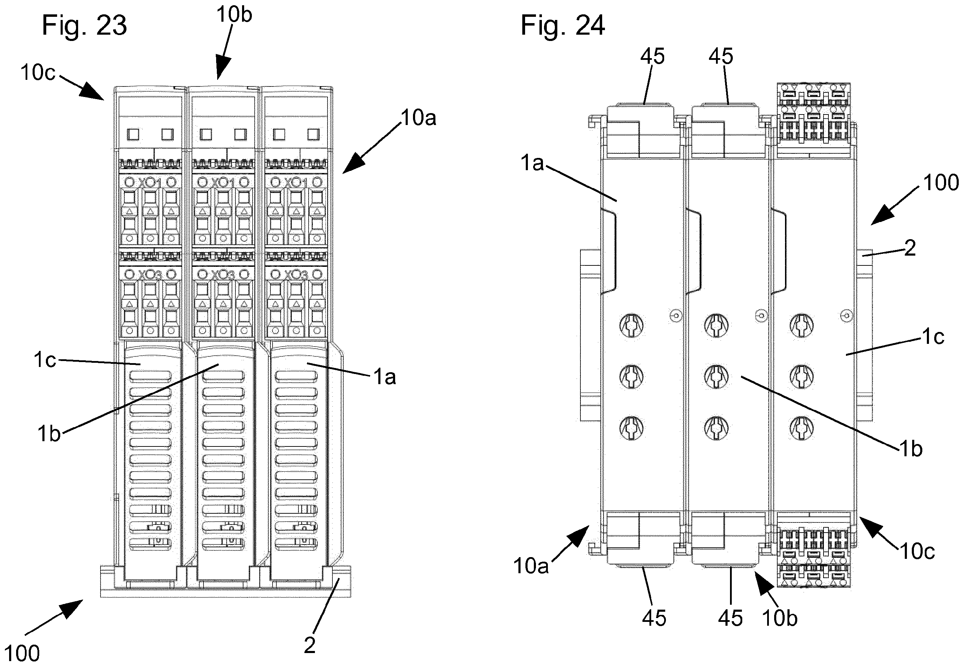

Nach der Montage des Systems 100 an der Tragschiene 2 ist es grundsätzlich möglich, einzelne Elektronikmodule 10a, 10b, 10c wieder zu demontieren, ohne dabei das gesamte System 100 von der Tragschiene 2 entfernen zu müssen. Unter Bezugnahme auf Fig. 24 bis 26 soll nachfolgend die Demontage eines der Elektronikmodule 10a, 10b, 10c näher erläutert werden. Fig. 24 zeigt wiederum ein System 100, welches drei Elektronikmodule 10a, 10b, 10c umfasst, die in der oben beschriebenen Weise mit Hilfe zweier Busverbinder 5 elektrisch und mechanisch miteinander verbunden sind.

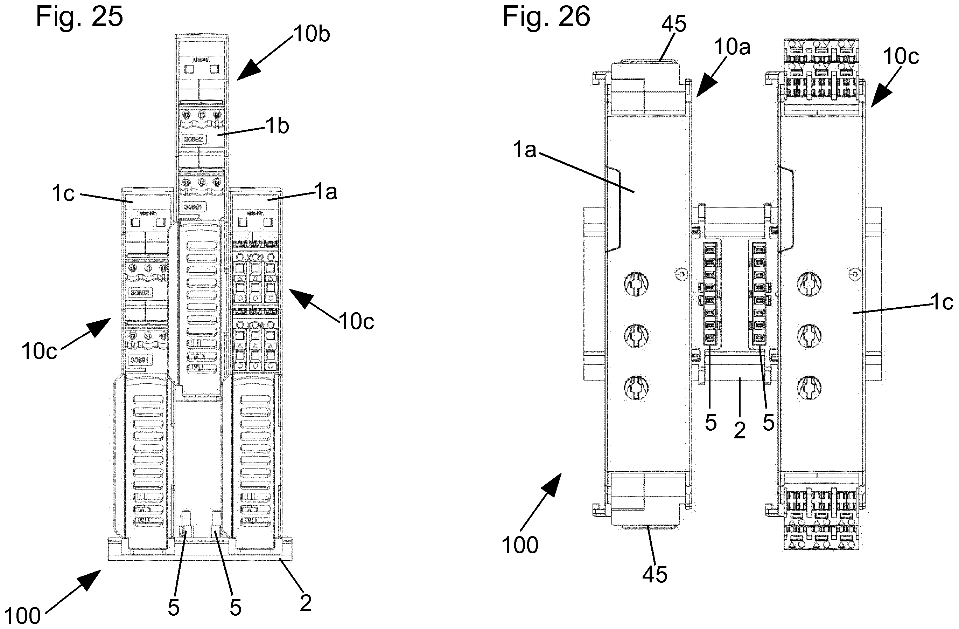

Um das in der Mitte des Systems 100 zwischen dem ersten Elektronikmodul 10a und dem dritten Elektronikmodul 10c angeordnete zweite Elektronikmodul 10b von der Tragschiene 2 lösen zu können, werden zunächst die beiden Rastschieber 4a, 4b des zweiten Elektronikmoduls 10b nach außen in eine Entriegelungsstellung überführt. Zu diesem Zweck kann zum Beispiel ein Schraubenzieher verwendet werden, der nacheinander in die Eingriffsöffnungen 46 der Handhabungsabschnitte 45 der einander gegenüberliegenden Rastschieber 4a, 4b des zweiten Elektronikmoduls 10b eingesetzt wird, um diese nach außen zu bewegen, so dass die Rastvorsprünge 48, die an den Biegebalken 47 der Rastschieber 4a, 4b des zweiten Elektronikmoduls 10b ausgebildet sind, nicht mehr in die zugehörigen Rastaufnahmen 12 an der Montageseite des Tragschienengehäuses 1b des zweiten Elektronikmoduls 10b eingreifen und damit das Tragschienengehäuse 1b freigeben. Das betreffende Tragschienengehäuse 1b kann dann - wie in Fig. 25 zu erkennen - nach vorne von der Tragschiene 2 abgezogen werden. Das erste Elektronikmodul 10a und das dritte Elektronikmodul 10c bleiben an der Tragschiene 2 montiert und halten überdies die beiden Busverbinder 5 in ihren Positionen. Nachfolgend kann ein Elektronikmodul ohne Busverbinder 5, welches das zweite Elektronikmodul 10b ersetzen soll und entsprechende Rastschieber 4a, 4b aufweist, in der oben beschriebenen Weise auf die beiden Busverbinder 5, die an den Tragschienengehäusen 1a, 1c des ersten und des dritten Elektronikmoduls 10a, 10c angebracht sind, aufgesteckt werden. Alternativ ist es auch möglich, das erste Elektronikmodul 10a und das dritte Elektronikmodul 10c auf der Tragschiene 2 weiter nach außen zu verschieben, so dass zwei oder mehrere, jeweils mit einem Busverbinder 5 miteinander verbundene Elektronikmodule zwischen dem ersten Elektronikmodul 10a und dem dritten Elektronikmodul 10c an der Tragschiene 2 befestigt werden können. Das System 100 ist nach dem Austausch des zweiten Elektronikmoduls 10b durch eines oder mehrere Elektronikmodule sofort wieder betriebsbereit.

Das hier beschriebene Befestigungs- und Verbindungskonzept ermöglicht somit auf einfache Weise auch eine nachträgliche Erweiterung des an der Tragschiene 2 angebrachten Systems 100, ohne dass dieses zu diesem Zweck vollständig von der Tragschiene 2 demontiert werden muss.

## Patentansprüche

1. Tragschienengehäuse (1a, 1b, 1c), geeignet zur Anbringung an einer Tragschiene (2), insbesondere einer Hutschiene, die zwei sich in Längsrichtung erstreckende und nach außen weisende Halteschenkel (20, 21) aufweist, umfassend
- eine Tragschienenaufnahmeöffnung (3), in die die Halteschenkel (20, 21) der Tragschiene (2) einsetzbar sind, und
- Rastmittel, die dazu ausgebildet sind, die Halteschenkel (20, 21) in ihrer Montagesolllage innerhalb der Tragschienenaufnahmeöffnung (3) festzulegen,
wobei das Tragschienengehäuse (1a, 1b, 1c) zumindest ein Steckkontaktelement (6), das in Richtung der Tragschienenaufnahmeöffnung (3) weisend innerhalb des Tragschienengehäuses (1a, 1b, 1c) angeordnet ist und eine Anzahl von Steckkontakten (62) umfasst, sowie zumindest einen Busverbinder (5), in den zumindest einige der Steckkontakte (62) des Steckkontaktelements (6) eingesetzt sind, aufweist, wobei der Busverbinder (5) mit einem Steckkontaktelement (6) zumindest eines weiteren Tragschienengehäuses (1b, 1c) elektrisch und mechanisch verbindbar ist und wobei die Rastmittel zwei Rastschieber (4a, 4b) umfassen, die an einer Montageseite des Tragschienengehäuses (1a, 1b, 1c) verschiebbar angeordnet sind und in einer Verriegelungsstellung mit dem Tragschienengehäuse (1a, 1b, 1c) verrastbar sind, wobei jeder der Rastschieber (4a, 4b) ein erstes Ende aufweist, das einen Halteabschnitt (44) aufweist, der sich in der Verriegelungsstellung abschnittsweise in die Tragschienenaufnahmeöffnung (3) hinein erstreckt, so dass der Busverbinder (5) innerhalb der Tragschienenaufnahmeöffnung (3) zwischen den Halteabschnitten (44) der Rastschieber (4a, 4b) und dem Steckkontaktelement (6) festgelegt ist, **dadurch gekennzeichnet, dass** der Busverbinder (5) einen Grundkörper (50) mit zwei einander gegenüberliegenden Enden umfasst, an denen jeweils eine Schrägfläche (51, 52) ausgebildet ist, wobei die Schrägflächen (51, 52) dazu eingerichtet sind, die Rastschieber (4a, 4b) beim Einsetzen des Busverbinders (5) in die Tragschienenaufnahmeöffnung (3) des Tragschienengehäuses (1a, 1b, 1c) nach außen zu verschieben.

2. Tragschienengehäuse (1a, 1b, 1c) nach Anspruch 1, **dadurch gekennzeichnet, dass** jeder der Rastschieber (4a, 4b) ein Rastelement umfasst und dass das Tragschienengehäuse (1a, 1b, 1c) zwei Rastausnehmungen (12) aufweist, wobei in der Verriegelungsstellung der Rastschieber (4a, 4b) in jede der beiden Rastausnehmungen (12) eines der Rastelemente eingreift.

3. Tragschienengehäuse (1a, 1b, 1c) nach Anspruch 2, **dadurch gekennzeichnet, dass** die Rastelemente als Biegebalken (47) ausgebildet sind, die sich von dem Halteabschnitt (44) in Richtung eines zweiten Endes des betreffenden Rastschiebers (4a, 4b) erstrecken und einen Rastvorsprung (48) umfassen, der in der Verriegelungsstellung in die dem Rastschieber (4a, 4b) zugeordnete Rastausnehmung (12) eingreift.

4. Tragschienengehäuse (1a, 1b, 1c) nach Anspruch 3, **dadurch gekennzeichnet, dass** jeder der Biegebalken (47) so ausgebildet ist, dass er bei einer Verschiebung des Rastschiebers (4a, 4b) nach außen von der Tragschienenaufnahmeöffnung (3) weg im Zusammenwirken mit der Rastausnehmung (12), in die der Rastvorsprung (48) eingreift, eine auf den Rastschieber (4a, 4b) in Richtung der Tragschienenaufnahmeöffnung (3) wirkende Rückstellkraft erzeugt.

5. Tragschienengehäuse (1a, 1b, 1c) nach einem der Ansprüche 1 bis 4, **dadurch gekennzeichnet, dass** sich die Halteschenkel (20, 21) in der Montagesolllage der Tragschiene (2) zwischen dem Busverbinder (5) und den Halteabschnitten (44) der Rastschieber (4a, 4b) erstrecken.

6. Tragschienengehäuse (1a, 1b, 1c) nach einem der Ansprüche 1 bis 5, **dadurch gekennzeichnet, dass** jeder der Rastschieber (4a, 4b) einen Handhabungsabschnitt (45) aufweist, der an einem zweiten Ende, welches dem ersten Ende gegenüberliegt, ausgebildet ist.

7. Elektronikmodul (10a, 10b, 10c), umfassend ein Tragschienengehäuse (1a, 1b, 1c), das an einer Tragschiene (2), insbesondere einer Hutschiene, anbringbar ist, **dadurch gekennzeichnet, dass** das Tragschienengehäuse (1a, 1b, 1c) nach einem der Ansprüche 1 bis 6 ausgeführt ist.

8. System (100), insbesondere Steuerungssystem, mit einer Mehrzahl von Elektronikmodulen (10a, 10b, 10c), die an einer Tragschiene (2) anbringbar sind, **dadurch gekennzeichnet, dass** zumindest eines der Elektronikmodule (10a, 10b, 10c) nach Anspruch 7 ausgeführt ist und mittels des Busverbinders (5) elektrisch und mechanisch mit einem benachbarten Elektronikmodul (10a, 10b, 10c) verbunden ist.

9. System (100) nach Anspruch 8, **dadurch gekennzeichnet, dass** eines der Elektronikmodule (10a, 10b, 10c) ein Abschlussmodul des Systems (100) bildet und einen Terminierungsstecker (13) aufweist.

## Claims

1. Carrier rail housing (1a, 1b, 1c) suitable for attachment to a carrier rail (2), in particular a top-hat rail, which has two holding legs (20, 21) that extend in the longitudinal direction and face outwards, said carrier rail housing (1a, 1b, 1c) comprising:
- a carrier rail receiving opening (3) into which the holding legs (20, 21) of the carrier rail (2) are insertable, and
- latching means which are configured to secure the holding legs (20, 21) in their desired mounting position inside the carrier rail receiving opening (3), wherein the carrier rail housing (1a, 1b, 1c) has at least one plug-in contact element (6) which is arranged inside the carrier rail housing (1a, 1b, 1c) so as to face in the direction of the carrier rail receiving opening (3) and comprises a number of plug-in contacts (62), and said carrier rail housing (1a, 1b, 1c) comprises at least one bus connector (5) into which at least some of the plug-in contacts (62) of the plug-in contact element (6) are insertable, wherein the bus connector (5) is electrically and mechanically connectable to a plug-in contact element (6) of at least one additional carrier rail housing (1b, 1c) and wherein the latching means comprise two latching slides (4a, 4b) which are arranged to be displaceable on a mounting side of the carrier rail housing (1a, 1b, 1c) and can be latched to the carrier rail housing (1a, 1b, 1c) in a locking position, wherein each of the latching slides (4a, 4b) has a first end that has a holding section (44) that extends in sections into the carrier rail receiving opening (3) in the locking position, such that the bus connector (5) is secured between the holding sections (44) of the latching slides (4a, 4b) and the plug-in contact element (6) inside the carrier rail receiving opening (3), **characterised in that** the bus connector (5) comprises a base body (50) with two mutually opposite ends, on each of which an inclined surface (51, 52) is formed, wherein the inclined surfaces (51, 52) are configured to move the latching slides (4a, 4b) outwards when the bus connector (5) is inserted into the carrier rail receiving opening (3) of the carrier rail housing (1a, 1b, 1c).

2. Carrier rail housing (1a, 1b, 1c) according to claim 1, **characterised in that** each of the latching slides (4a, 4b) comprises a latching element and **in that** the carrier rail housing (1a, 1b, 1c) has two latching recesses (12), wherein in the locking position of the latching slides (4a, 4b), one of the latching elements engages into each of the two latching recesses (12).

3. Carrier rail housing (1a, 1b, 1c) according to claim 2, **characterised in that** the latching elements are configured as bending beams (47) that extend from the holding section (44) in the direction of a second end of the respective latching slide (4a, 4b) and comprise a latching projection (48) which engages into the latching recess (12) associated with the latching slide (4a, 4b) in the locking position.

4. Carrier rail housing (1a, 1b, 1c) according to claim 3, **characterised in that** each of the bending beams (47) is configured such that when the latching slide (4a, 4b) is displaced outwards away from the carrier rail receiving opening (3), it generates, in interaction with the latching recess (12) into which the latching projection (48) engages, a restoring force that acts on the latching slide (4a, 4b) in the direction of the carrier rail receiving opening (3).

5. Carrier rail housing (1a, 1b, 1c) according to any of claims 1 to 4, **characterised in that** in the desired mounting position of the carrier rail (2), the holding legs (20, 21) extend between the bus connector (5) and the holding sections (44) of the latching slides (4a, 4b).

6. Carrier rail housing (1a, 1b, 1c) according to any of claims 1 to 5, **characterised in that** each of the latching slides (4a, 4b) has a handling section (45) formed on a second end that is opposite the first end.

7. Electronic module (10a, 10b, 10c), comprising a carrier rail housing (1a, 1b, 1c) which can be attached to a carrier rail (2), in particular a top-hat rail, **characterised in that** the carrier rail housing (1a, 1b, 1c) is designed according to any of claims 1 to 6.

8. System (100), in particular control system, having a plurality of electronic modules (10a, 10b, 10c) which can be attached to a carrier rail (2), **characterised in that** at least one of the electronic modules (10a, 10b, 10c) is designed according to claim 7 and is electrically and mechanically connected to an adjacent electronic module (10a, 10b, 10c) by the bus connector (5).

9. System (100) according to claim 8, **characterised in that** one of the electronic modules (10a, 10b, 10c) forms a terminal module of the system (100) and has a termination plug (13).

## Revendications

1. Boîtier de rail de support (1a, 1b, 1c), approprié pour être placé sur un rail de support (2), en particulier un profilé chapeau, qui présente deux branches de retenue (20, 21) s'étendant dans la direction longitudinale et dirigées vers l'extérieur, comprenant
- une ouverture de logement de rail de support (3), dans laquelle les branches de retenue (20, 21) du rail de support (2) sont insérables, et
- des moyens d'encliquetage, qui sont agencés pour fixer les branches de retenue (20, 21) dans leur position de montage de consigne à l'intérieur de l'ouverture de logement de rail de support (3), selon lequel le boîtier de rail de support (1a, 1b, 1c) présente au moins un élément de contact enfichable (6), qui est disposé orienté dans la direction de l'ouverture de logement de rail de support (3) à l'intérieur du boîtier de rail de support (1a, 1b, 1c) et comprend un certain nombre de contacts enfichables (62), ainsi qu'au moins un connecteur de bus (5), dans lequel au moins quelques-uns des contacts enfichables (62) de élément de contact enfichable (6) sont introduits, selon lequel le connecteur de bus (5) est électriquement et mécaniquement connectable à un élément de contact enfichable (6) d'au moins un autre boîtier de rail de support (1b, 1c) et selon lequel les moyens d'encliquetage comprennent deux coulisseaux d'encliquetage (4a, 4b), qui sont disposés de manière mobile d'un côté de montage du boîtier de rail de support (1a, 1b, 1c) et peuvent s'encliqueter dans une position de verrouillage avec le boîtier de rail de support (1a, 1b, 1c), selon lequel chacun des coulisseaux d'encliquetage (4a, 4b) présente une première extrémité qui présente une section de maintien (44) qui, dans la position de verrouillage, s'étend partiellement dans l'ouverture de logement de rail de support (3), de façon que le connecteur de bus (5) soit fixé à l'intérieur de l'ouverture de logement de rail de support (3), entre les sections de maintien (44) des coulisseaux d'encliquetage (4a, 4b) et l'élément de contact enfichable (6), **caractérisé en ce que** le connecteur de bus (5) comprend un corps de base (50) avec deux extrémités à l'opposé l'une de l'autre, au niveau desquelles, respectivement, une surface inclinée (51, 52) est agencée, selon lequel les surfaces inclinées (51, 52) sont configurées pour déplacer vers l'extérieur les coulisseaux d'encliquetage (4a, 4b) lors de l'introduction du connecteur de bus (5) dans l'ouverture de logement de rail de support (3) du boîtier de rail de support (1a, 1b, 1c).

2. Boîtier de rail de support (1a, 1b, 1c) selon la revendication 1, **caractérisé en ce que** chacun des coulisseaux d'encliquetage (4a, 4b) comprend un élément d'encliquetage et **en ce que** le boîtier de rail de support (1a, 1b, 1c) présente deux évidements d'encliquetage (12), selon lequel, dans la position de verrouillage, le coulisseau d'encliquetage (4a, 4b) s'encliquette dans chacun des deux évidements d'encliquetage (12) d'un des éléments d'encliquetage.

3. Boîtier de rail de support (1a, 1b, 1c) selon la revendication 2, **caractérisé en ce que** les éléments d'encliquetage sont agencés comme des barres de flexion (47), qui s'étendent à partir de la section de maintien (44) dans la direction d'une seconde extrémité du coulisseau d'encliquetage (4a, 4b) concerné, et comprennent une saillie d'encliquetage (48), qui, dans la position de verrouillage, s'encliquette dans l'évidemment d'encliquetage (12) associé au coulisseau d'encliquetage (4a, 4b).

4. Boîtier de rail de support (1a, 1b, 1c) selon la revendication 3, **caractérisé en ce que** chacune des barres de flexion (47) est agencée de façon que, lors d'un déplacement du coulisseau d'encliquetage (4a, 4b) vers l'extérieur de l'ouverture de logement de rail de support (3), en concomitance avec l'évidemment d'encliquetage (12), dans lequel la saillie d'encliquetage (48) s'encliquette, elle crée une force de rappel agissant sur le coulisseau d'encliquetage (4a, 4b) dans la direction de l'ouverture de logement de rail de support (3).

5. Boîtier de rail de support (1a, 1b, 1c) selon l'une des revendications 1 à 4, **caractérisé en ce que** les branches de retenue (20, 21), dans la position de montage de consigne du rail de support (2), s'étendent entre le connecteur de bus (5) et les sections de maintien (44) des coulisseaux d'encliquetage (4a, 4b).

6. Boîtier de rail de support (1a, 1b, 1c) selon l'une des revendications 1 à 5, **caractérisé en ce que** chacun des coulisseaux d'encliquetage (4a, 4b) présente une section de manipulation (45) qui est agencée à une seconde extrémité, laquelle est opposée à la première extrémité.

7. Module électronique (10a, 10b, 10c), comprenant un boîtier de rail de support (1a, 1b, 1c) qui peut être placé sur un rail de support (2), en particulier sur un profilé chapeau, **caractérisé en ce que** le boîtier de rail de support (1a, 1b, 1c) est réalisé selon l'une des revendications 1 à 6.

8. Système (100), en particulier un système de commande, avec une pluralité de modules électroniques (10a, 10b, 10c), qui peuvent être placés sur un rail de support (2), **caractérisé en ce qu'**au moins un des modules électroniques (10a, 10b, 10c) est réalisé selon la revendication 7 et est connecté électriquement et mécaniquement au moyen du connecteur de bus (5) à un module électronique (10a, 10b, 10c) voisin.

9. Système (100) selon la revendication 8, **caractérisé en ce qu'**un des modules électroniques (10a, 10b, 10c) constitue un module de terminaison du système (100) et présente une prise de terminaison (13).
